# EUROPÄISCHE PATENTSCHRIFT

(11) **EP 0 397 727 B1**
(45) Veröffentlichungstag und Bekanntmachung des Hinweises auf die Patenterteilung: **05.04.1995**
(21) Anmeldenummer: 89901460.9
(22) Anmeldetag: 21.01.1989
(51) Int. Cl.: H01L 29/73, H03K 17/12

(54) **ELEKTRONISCHES GERÄT**
ELECTRONIC APPLIANCE
APPAREIL ELECTRONIQUE

(30) Priorität: 30.01.1988 DE 3802767
(43) Veröffentlichungstag der Anmeldung: 22.11.1990
(73) Patentinhaber: ROBERT BOSCH GMBH, 70442 Stuttgart (DE)
(72) Erfinder: CONZELMANN, Gerhard, D-7022 Leinfelden-Oberaichen (DE); HAACK, Dietmar, D-7417 Reutlingen 17 (DE); FIEDLER, Gerhard, D-7441 Neckartailfingen (DE)
(86) Internationale Anmeldenummer: DE8900034
(87) Internationale Veröffentlichungsnummer: WO8907340

## Beschreibung

### Elektronisches Gerät

### Stand der Technik

Die Erfindung betrifft ein elektronisches Gerät mit einem monolithisch integrierten Leistungstransistor nach der Gattung des Hauptanspruchs.

Ein elektronisches Gerät mit einem monolithisch integrierten Leistungstransistor dieser Art ist aus der US-A-4 656 496 bekannt. Die insgesamt erforderliche Emitterfläche des Leistungstransistors ist hierbei in eine große Anzahl von Teilemittern mit je einem Widerstand in der Zuleitung zu dem Teilemitter aufgespalten. Durch diese Maßnahme läßt sich die Stromverteilung im Gesamtverband des Leistungstransistors wirksam stabilisieren, sofern ein hinreichend großer Spannungsabfall bei maximalem Strom zur Verfügung gestellt wird. Das bekannte elektronische Gerät weist zur Strombegrenzung bei "hat spot" - Problemen eine eigene Teiltransistorstruktur ("extended sense emitter") ohne Ballastwiderstand auf, die sich benachbart zu den üblichen, parallel geschalteten Teiltransistoren mit Ballastwiderständen erstreckt und Temperaturerhöhungen erfaßt. Für Anwendungen des Leistungstransistors in elektronischen Geräten mit Stromregelung bzw. Strombegrenzung (vgl. hierzu die Schaltungsanordnungen nach der US-A-4 567 537) wäre ein zusätzlicher Meßwiderstand und damit ein zusätzlicher Spannungsabfall erforderlich, was ein Ansteigen der Sättigungsspannung des Leistungstranistors im Betrieb bedeuten würde.

### Vorteile der Erfindung

Das erfindungsgemäße elektronische Gerät mit einem monolithisch integrierten Leistungstransistor mit den kennzeichnenden Merkmalen des Hauptanspruchs hat demgegenüber den Vorteil, daß ein Meßwiderstand zur Gewinnung einer dem Strom proportionalen Signalspannung für einen Regelkreis, in den der monolithisch integrierte Leistungstransistor einbezogen ist, bereitgestellt wird, ohne daß dadurch die Sättigungsspannung des Leistungstransistors erhöht wird. Ein weiterer Vorteil besteht darin, daß für den Meßwiderstand keine zusätzliche Chipfläche benötigt wird, da sich die Widerstände in den Emitterzuleitungen flächenneutral auf der von dem Leistungstransistor insgesamt benötigten Fläche unterbringen lassen, die maßgeblich von der durch den Leistungstransistor abzuführenden Verlustleistung bestimmt wird. Weitere Vorteile ergeben sich aus den Unteransprüchen 2 bis 30, die spezielle Ausführungsformen der Erfindung betreffen, und aus der Beschreibung.

### Zeichnung

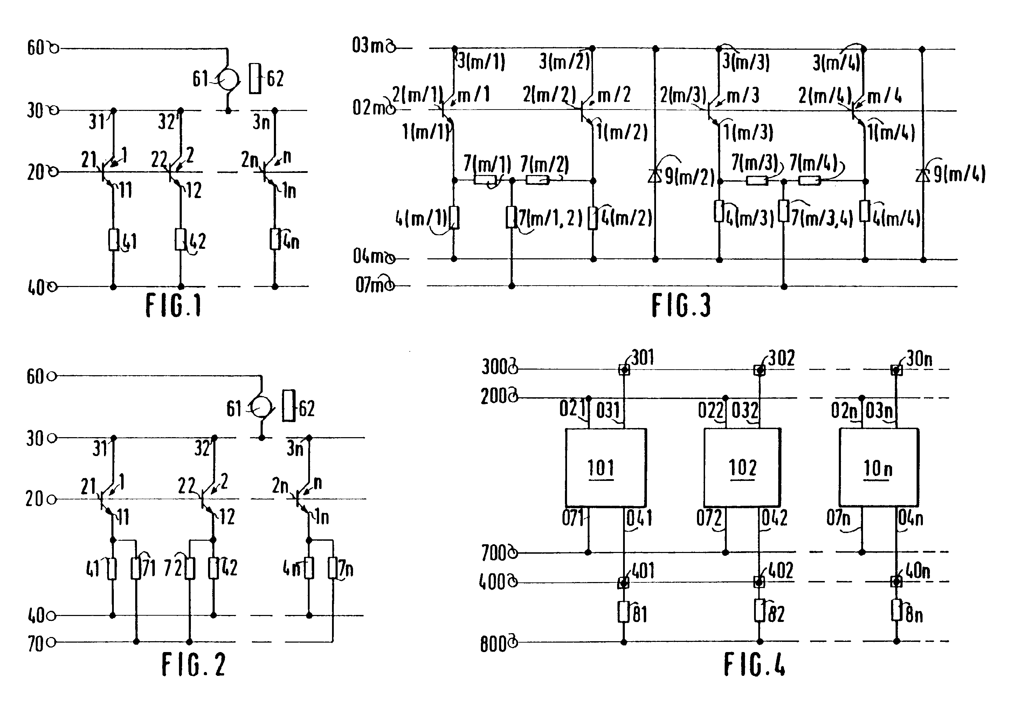

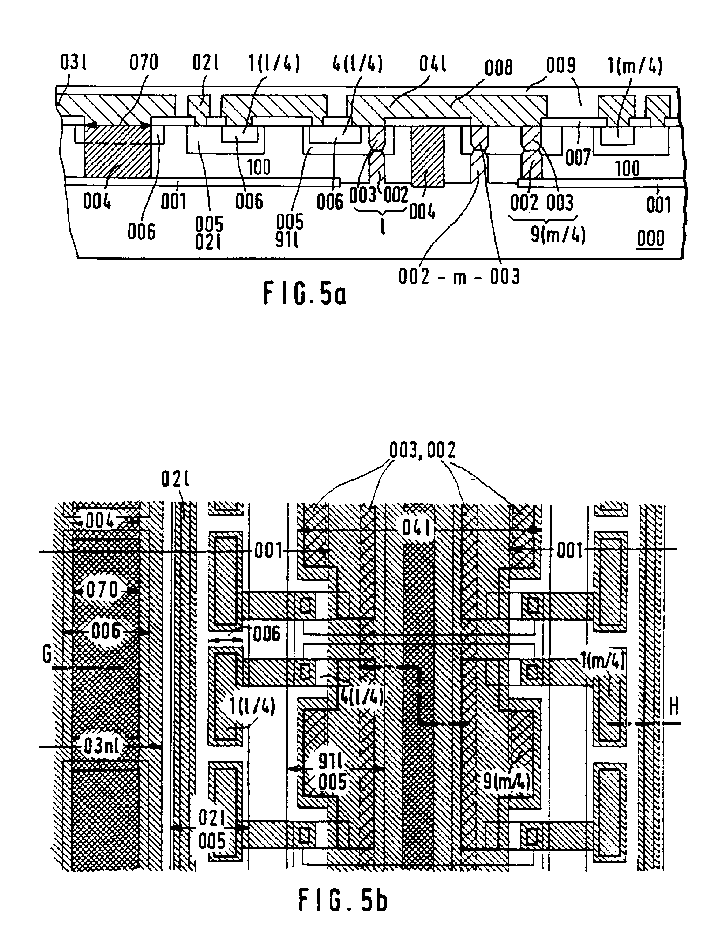

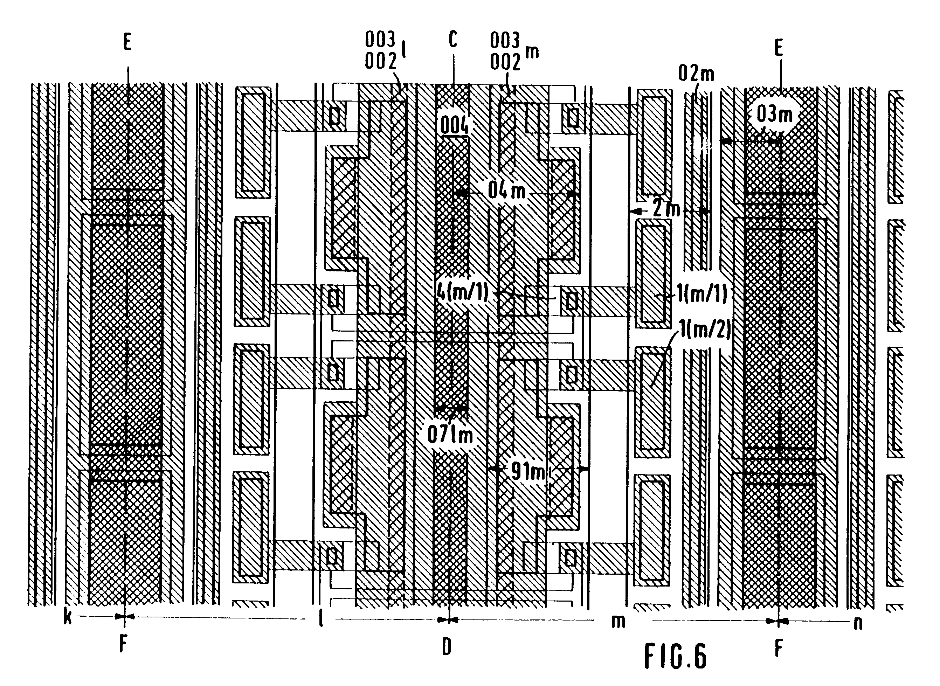

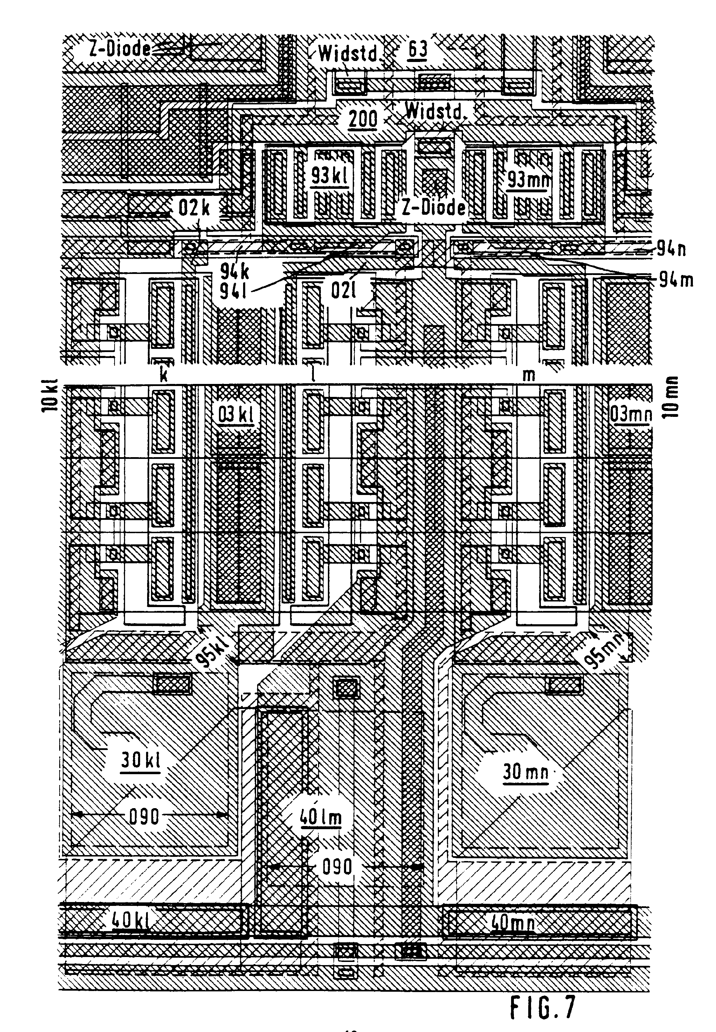

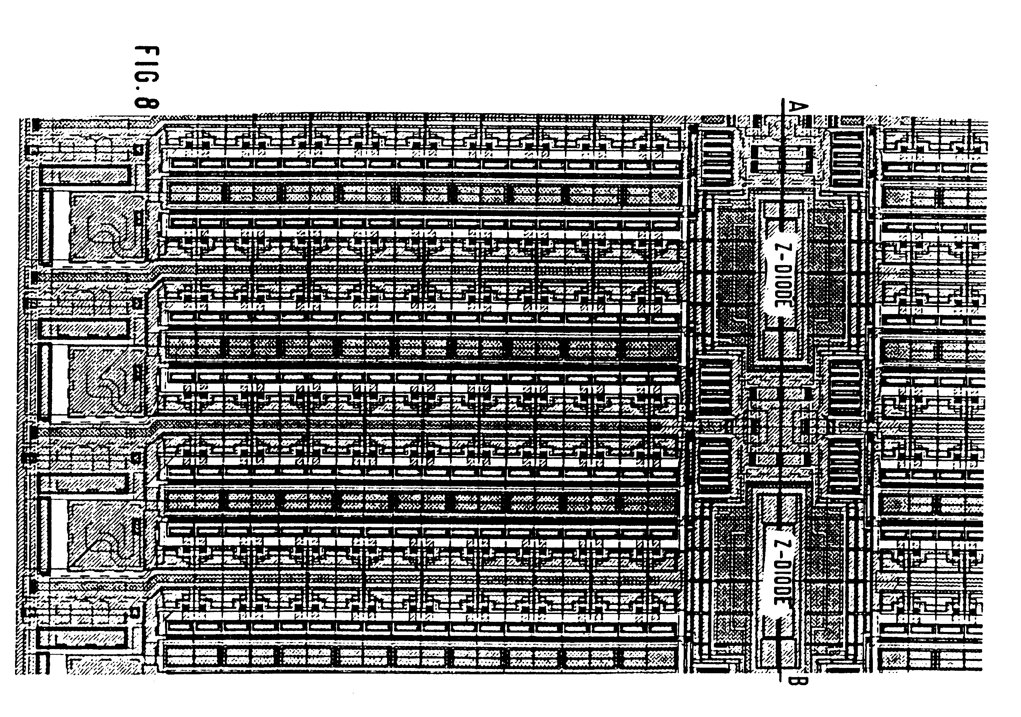

Die Erfindung wird anhand der Zeichnung näher erläutert. Figur 1 zeigt ein elektronisches Gerät nach dem Stand der Technik mit einem Elektromotor im Kollektorstromkreis des Leistungstransistors. Der Transistor besteht bekanntermaßen aus einer Vielzahl parallelgeschalteter Einzeltransistoren mit Widerständen in den Emitterzuleitungen. Figur 2 zeigt eine Anordnung gemäß der Erfindung, bei der erfindungsgemäß die Widerstände in den Emitterzuleitungen der Einzeltransistoren als Meßwiderstände zur Gewinnung einer dem Strom proportionalen Signalspannung herangezogen werden, wobei zur Auskopplung der Signalspannung zusätzliche Widerstände vorgesehen sind. In Figur 3 ist die Schaltung einer layoutgerechten Anordnung als Ausschnitt einer Zelle des Leistungstransistors gezeigt, in Figur 4 die Zusammenschaltung der einzelnen Zellen zum Verband des Leistungstransistors. Ausschnitte aus dem Layout geben die Figuren 5 bis 8 wieder. In Figur 5 sind anhand eines Schnittes (Figur 5a) und eines Layout-Ausschnitts (Figur 5b) die Maskenebenen des verwendeten Prozesses erläutert. Figur 6 zeigt den Layout-Ausschnitt der Schaltung nach Figur 3 mit einem Zenerdioden-Element als zusätzliche Komponente einer Zelle des Leistungstransistors, Figur 7 im Ausschnitt die Zusammenschaltung der in der Figur 6 genannten Komponenten zum Verband des Leistungstransistors mit den den Zellen zugeordneten Treiberstufen und Figur 8 die Bildung eines Leistungstransistors nach Figur 7 mit einer doppelzeiligen Anordnung der Zellen.

### Beschreibung der Erfindung

In Figur 1 sind mit 1, 2, ..., n die durch die Aufspaltung der gesamten Emitterfläche in eine Vielzahl von Einzelemittern entstandenen Einzeltransistoren bezeichnet: 11, 12, ..., 1n sind ihre Emitter, 21, 22, ..., 2n ihre Basen und 31, 32, ..., 3n ihre Kollektoren, mit 41, 42, ..., 4n sind die Widerstände in den Zuleitungen zu den Einzelemittern bezeichnet; 40 ist der Emitteranschluß, 20 der Basisanschluß und 30 der Kollektoranschluß des durch die Parallelschaltung entstandenen Leistungstransistors. Zwischen dem Kollektoranschluß 30 und der Klemme 60 zum positiven Pol der Betriebsspannung liegt als Beispiel einer Last der Anker 61 eines Gleichstrommotors mit dem permanenten Feld 62; an eine Klemme 40 ist der negative Pol der Betriebsspannung angeschlossen.

Figur 2 zeigt dieselbe Konfiguration wie Figur 1, jedoch ergänzt durch Widerstände 71, 72, ..., 7n, die einerseits an die Emitter der Teiltransistoren, andererseits an eine Leitung 70 zum Auskoppeln einer Signalspannung angeschlossen sind. Diese Leitung kann besonders bei in der Technologie vorhandener Mehrlagenverdrahtung metallisch ausgeführt sein. Sie läßt sich jedoch auch "vergraben" mittels niederohmiger Diffusionszonen darstellen.

Besonders vorteilhaft ist es, die Widerstände 41, 42, ..., 4n im Layout in unmittelbarer Nachbarschaft der zugehörigen Emitter anzuordnen, sie also thermisch eng an den Emitter zu koppeln, und ihnen einen positiven Temperaturkoeffizienten zu geben. Für den Einsatz dieses Leistungstransistors als Endglied einer Regelschaltung bedeutet der positive Temperaturkoeffizient keinen Nachteil, da sich mit bekannten Mitteln der integrierten Schaltungstechnik nahezu jeder beliebige Temperaturgang der Regelschaltung darstellen läßt und sich somit auch der Temperturkoeffizient der in den Emitterzuleitungen liegenden Meßwiderstände kompensieren läßt. Im vorliegenden Beispiel sind sie in Emitterdiffusion dargestellt; sie sind aber ebenso mittels einer anderen Diffusion oder etwa mittels Polysilizium auszuführen.

Für das Layout eines integrierten Leistungstransistors ist es vorteilhaft, eine Vielzahl der Teiltransistoren nach Figur 1 oder 2 zu Zellen zusammenzufassen, wobei der Leistungstransistor dann wiederum aus der Parallelschaltung einer Vielzahl von Zellen besteht.

In Figur 3, dem Schaltungsausschnitt eines im Layout ausgeführten Beispiels, sind die Zellen nochmals in Halbzellen unterteilt und Komponenten für die m-te Halbzelle eingetragen. Es sind 02m, 03m, 04m und 07m die Sammelleitungen für Basis-, Kollektor-, Emitteranschluß und Signalspannung, ferner m/1, m/2, m/3, m/4 paarweise zusammengefaßte Teiltransistoren mit ebenso paarweise angeordneten Widerständen 7 (m/n). Die Widerstände 7 (m/1) und 7 (m/2) bzw. 7 (m/3) und 7 (m/4) liegen mit jeweils einem Ende an den Emittern 1 (m/1) bzw. 1 (m/2) usw. der Transistoren m/1 bzw. m/2 usw., während ihre anderen Enden miteinander verbunden und über den Widerstand 7 (m/1, 2) an die Signalleitung 07m angeschlossen sind.

Da die Breite einer Zelle einerseits durch die nebeneinanderliegenden Anschlußflächen für Emitter und Kollektor, andererseits aber durch die abzuführende Verlustleistung bestimmt ist, lassen sich nicht nur die Widerstände 4 (m/1), ... in den Emitterzuleitungen und die zugehörigen Widerstände 7 (m/1), ... zum Auskoppeln der Signalspannung über eine vergrabene Leitung 07m, ... flächenneutral unterbringen, sondern auch noch eine Avalanche-Diode 9 hoher Verlustleistung, deren Durchbruchspannung sicher unterhalb der Kollektor-Emitter-Haltespannung des Leistungstransistors eingestellt ist, beispielsweise durch die Implantations-Dosis der "unteren" Isolierungsdiffusion. Die Avalanche-Diode 9 besteht aus Elementen 9 (m/2), 9 (m/4), ..., die jeweils in Lücken untergebracht sind, die zwischen je zwei Widerstandspaaren freigelassen sind. Diese Avalanche-Dioden sind besonders bei induktiven Lasten zweckmäßig, da sie den nach dem Ausschalten noch weiter fließenden Kollektorstrom üjernenhmen und Spannungsdurchschläge verhindern.

Das Layout einer Zelle entsteht nun, wie weiter unten noch gezeigt wird, aus dem Layout einer Halbzelle durch Spiegeln der Halbzelle an demjenigen Rand der Halbzelle, bis zu dem sich die Kollektoranschlußsammelleitung bzw. die Kollektoranschlußdiffusion der Halbzelle erstreckt.

Die Parallelschaltung einzelner Zellen 101, 102, ..., 10n mit ihren Elektroden 02n, 03n, 04n und 07n zum Leistungstransistor mit den sinngemäßen Anschlüssen 200, 300, 400 und 700 ist in Figur 4 dargestellt. Darüber hinaus ist eine "Referenzmasse" 800 eingeführt.

Für das Layout einer monolithisch integrierten Schaltung mit einem stromstarken Leistungstransistor gemäß der Erfindung kann es vorteilhaft sein, die Zellen so aufzubauen, daß die Anschlußflecken von Emitter und Kollektor jeder Zelle nebeneinander liegen. Jeder dieser Anschlußflecken läßt sich dann auf dem kürzesten Weg mit den nach außen führenden Anschlüssen 300 und 400 verbinden, beispielsweise mittels durch Automaten gezogenen Bonddrähten. Unabhängig davon jedoch, ob der Emitteranschluß 041, 042, 04n jeder Zelle direkt mittels eines Bonddrahts nach außen geführt ist oder bei einer anderen Zusammenfassung im Layout zum gemeinsamen Emitter 400, ergeben sich bei den vorliegenden großen Strömen störende Potentialdifferenzen zwischen den Punkten 401, 402, 40n. Um diese Potentialdifferenzen auszumitteln, sind die genannten Punkte über Widerstände 81, 82, ... 8n mit der Leitung 800 verbunden, die ein stromunabhängiges Massepotential einem in der Zeichnung nicht dargestellten Regelverstärker zuführt.

In den Figuren 5a und 5b ist beispielhaft ein möglicher Prozeß zur Darstellung des Gegenstands der Erfindung auf monokristallinem Silizium schematisch, d.h. ohne den Versatz durch Unterätzung und Unterdiffusion usw., dargestellt. Es bedeuten:
- 000: Substrat (p⁻)
- 001: Leitschicht (n⁺)
- 002: untere Isolierungsdiffusion (p⁺)
- 100: Epitaxie (n⁻)
- 003: obere Isolierungsdiffusion (p⁺)
- 004: Kollektoranschluß-Diffusion (n⁺)
- 005: Basisdiffusion (p)
- 006: Emitterdiffusion (n⁺)
- 007: Deckoxid
- 008: Metallisierung
- 009: Schutzschicht
- 070: Kontaktfenster in der Ebene 007

Die beiden Isolierungs-Diffusionen 002/003 sind weit, die Kollektoranschluß-Diffusion 004 eng von links unten nach rechts oben schraffiert, das strukturierte Metall 008 dagegen von links oben nach rechts unten. Die Schutzschicht 009 kann aus einem Silan- oder Plasma-Oxid oder aus einem Plasma-Nitrid bestehen.

Figur 5a stellt einen Schnitt entlang der Linie GH von Figur 5b dar. Ferner sind die Bezeichnungen der geschnittenen Komponenten entsprechend den Figuren 3 und 4 mit eingetragen.

Figur 5b ist das Plot des zugehörigen Layouts in gleicher Darstellung. Die kräftigsten Linien zeigen die Umrisse der Kontaktfenster, die beiden schwächsten die von Emitter und Leitschicht. Die Basis ist nur wenig schwächer als die Kontaktfenster gezeichnet. Zusammen mit dem Schnitt nach Figur 5a lassen sich die entsprechenden Zonen eindeutig zuordnen.

Das Layout nach Figur 6 weist die topologische Anordnung der Komponenten nach Figur 4 und 5 aus. Die bereits bekannten Komponenten tragen wieder dieselben Bezeichnungen. Da sie sich stets wiederholen, sind sie nur einmal innerhalb einer Halbzelle bezeichnet. Die Zelle entsteht nun aus der Halbzelle durch Spiegeln an der Symmetrieachse EF der Zelle. Ebenso entsteht der Zellverband aus den einzelnen Zellen jeweils durch Aneinanderreihen einzelner Zellen entlang ihrer Grenzen CD bzw. wegen ihrer Symmetrie auch durch Spiegeln an einer der Symmetrieachsen CD.

Die metallischen Leitungen sind ebenfalls wieder von links oben nach rechts unten schraffiert. Entsprechend sind 02m die Basissammelleitung, 03m die Kollektorsammelleitung und 04m die Emittersammelleitung der m-ten Halbzelle. Die Teilemitter 1 (m/1), 1 (m/2), ... liegen im gemeinsamen Basisgebiet 2m, das mit 02m angeschlossen ist.

Die Widerstände 4 (m/1), 4 (m/2), ... sind in einem mittels der Emittersammelleitung 04m an Masse angeschlossenen Basisgebiet 91m untergebracht. Die Kollektorzonen der einzelnen Zellen sind gegeneinander isoliert mittels der genannten "unteren" und "oberen" Isolierungsdiffusion, dargestellt durch die weit von links unten nach rechts oben schraffierten Teilstücke 0021, 0031 und 002m, 003m zu beiden Seiten der Leitung 071m, wobei die Leitung 071m zum Auskoppeln der Signalspannung dient und vergraben unter der Emittersammelleitung 041m liegt. Die Leitung 071m ist in diesem Falle mit der stark n-dotierten Kollektoranschluß-Diffusion 004 ausgeführt.

Die Zusammenfassung von Ausschnitten nach Figur 6 zu einem Teil des Leistungstransistors von 3 Halbzellen ist in Figur 7 wiedergegeben mit den Kollektoranschlußflecken 30kl, 30mn, ... und dem Emitteranschlußfleck 401m, der über die Leitungsstücke 40kl und 40mn mit den jeweils benachbarten Emitteranschlußflecken verbunden ist. Um den Basisstrom in der Zuleitung 200 und damit deren Leiterbahnbreite hinreichend klein zu halten, sind den Zellen 101, 102, ... jeweils noch Treiberstufen 93kl, 93mn, ... zugeordnet, die jeweils zwei Halbzellen bedienen und mit weiteren Komponenten wie Zenerdioden, Widerständen usw. auf der den Anschlußflecken abgewandten Seite der Zellen angeordnet sind.

Ferner sind die Widerstände 94k und 94l, 94m und 94n, ... dazugekommen, die zwischen die Basisleitungen 02k, 02l, 02m und 02n, ... der Halbzellen und die Emitter der Treibertransistoren 93kl und 93mn, ... geschaltet sind, sowie die Engstellen 95kl, 95mn, ... in der Metallisierung zwischen den Anschlußflecken 30kl, 30mn, ... und den Kollektorleitungen 03kl, 03mn, ... der Zellen und die Leitung 63, die zum positiven Pol der Betriebsspannung führt. Weitere Komponenten der monolithisch integrierten Schaltungsanordnung sind leicht oberhalb des gezeigten Layout-Ausschnitts anzuordnen.

Kostengünstig zu fertigende monolithisch integrierte Leistungstransistoren erfordern eine hohe Flächenleistungsdichte, wie sie beispielsweise durch Löten zu erreichen ist. Da es in einer Großserie jedoch nicht gelingt, absolut lunkerfrei zu löten und bei der Schlußprüfung Exemplare mit feinen Lunkern sicher zu erfassen, ist ein "Selbstheileffekt" unabdingbar, um eine hohe Zuverlässigkeit zu erreichen. Dieser Selbstheileffekt wird erreicht durch die Engstellen 95kl, 95mn, ... zwischen Kollektoranschlußfleck 30kl, 30mn, ... und Kollektorsammelleitung 03kl, 03mn, ... Wird ein Teil einer Zelle oder auch mehrerer Zellen durch einen darunterliegenden Lunker überhitzt, geht also in die Eigenleitung, so übernimmt der betroffene Teil den insgesamt möglichen Strom, die Engstelle bzw. die Engstellen brennen durch. Damit ist die Zelle, in der der zerstörte Teil liegt, von dem gesund gebliebenen Rest des Leistungstransistors abgetrennt. Damit jetzt die mit ihrem Emitter direkt verschmolzene Basis der zerstörten Zelle den gesund gebliebenen Zellen nicht des Basisstrom wegnimmt, sind die Widerstände 94k, 94l, 94m und 94n, ... zwischen die Basissammelleitungen 02k und 02l bzw. 02m und 02n, ... zweier Halbzellen und die gemeinsame Basissammelleitung 200 des Zellverbandes bzw. der Transistorzeile geschaltet. Sie können dabei vor den Treibertransistoren oder, wie hier dargestellt, nach den Treibertransistoren innerhalb der zwischen Leistungstransistorzeile und Treibertransistorzeile verlaufenden Zone der Isolierungsdiffusion flächenneutral angeordnet und mittels der Emitterdiffusion dargestellt sein.

Für großflächige monolithisch integrierte Schaltungen empfiehlt es sich, wie in Figur 8 gezeigt, die zu einer Zeile zusammengefaßten Zellen entlang einer Achse AB zu spiegeln und weitere Schaltungsteile links und/oder rechts von dem den Leistungstransistor bildenden Zellverband anzuordnen.

Eine Halbzelle des hier im Ausschnitt gezeichneten Ausführungsbeispiels enthält 18 Teilemitter bzw. Teiltransistoren. Sie bleibt bei einem Strom von 0,5 A und einer Belastung von ca. 7 W frei von "second breakdown". Der Leistungstransistor wurde aus 56 Halbzellen aufgebaut. Ohne die Kennwerte des mit ihm zusammenarbeitenden Stromreglers nennenswert zu beeinflussen, konnten sich bis zu 4 Zellen infolge Überlast abtrennen.

## Patentansprüche

1. Elektronisches Gerät mit einem Regelkreis zur Stromregelung bzw. Strombegrenzung, in den ein monolithisch integrierter bipolarer Leistungstransistor, bestehend aus der Parallelschaltung einer Vielzahl einzelner Teiltransistoren (1, 2, 3, ..., n) mit Widerständen (41, 42, 43, ..., 4n) in ihren Emitterzuleitungen zur Stabilisierung der Verteilung des Summenstroms auf die einzelnen Teiltransistoren (1, 2, 3, ..., n) einbezogen ist, dadurch gekennzeichnet, daß mindestens einer der Widerstände (41, 42, 43, ..., 4n) in den Emitterzuleitungen als Meßwiderstand zur Gewinnung einer dem Strom proportionalen Signalspannung dient.

2. Elektronisches Gerät nach Anspruch 1, dadurch gekennzeichnet, daß die einzelnen Teiltransistoren (1, 2, 3, ..., n) in mehrere Gruppen zusammengefaßt sind, wobei eine Gruppe eine Zelle des Leistungstransistors bildet.

3. Elektronisches Gerät nach Anspruch 2, dadurch gekennzeichnet, daß die Kollektorgebiete der einzelnen Zellen (k, l bzw. m, n) gegeneinander isoliert sind, wobei vorzugsweise eine Vielzahl von Zellen des Leistungstransistors zu einer Transistorzeile zusammengefaßt ist.

4. Elektronisches Gerät nach Anspruch 3, dadurch gekennzeichnet, daß jeder Zelle (k, l bzw. m, n) einer Zeile des Leistungstransistors je ein nebeneinanderliegender Emitter- und Kollektoranschlußfleck für nach außen führende Emitter- bzw. Kollektoranschlußleitungen zugeordnet ist.

5. Elektronisches Gerät nach Anspruch 3, dadurch gekennzeichnet, daß die Zellen (k, l bzw. m, n) einer Zeile des Leistungstransistors jeweils aus zwei spiegelbildlich zueinander angeordneten Halbzellen (k und l bzw. m und n) bestehen, daß für beide Halbzellen (k und l bzw. m und n) eine gemeinsame Kollektorsammelleitung (03kl bzw. 03mn) vorgesehen ist, die in der Mitte der Zelle (k, l bzw. m, n) verläuft, und daß für beide Halbzellen (k und l bzw. m und n) voneinander getrennte Emittersammelleitungen (04k und 04l bzw. 04m und 04n) vorgesehen sind, die an den beiden Rändern der Zelle (k, l bzw. m, n) verlaufen und mit den jeweiligen Emittersammelleitungen (04ik bzw. 04lm bzw. 04no) der beiden Halbzellen, die den jeweils angrenzenden Zellen (h, i bzw. k, l bzw. m, n bzw. o, p) angehören, einstückig ausgebildet sind.

6. Elektronisches Gerät nach Anspruch 5, dadurch gekennzeichnet, daß für nach außen führende Kollektor- bzw. Emitteranschlußleitungen jeder Zelle (k, l bzw. m, n) des Leistungstransistors ein Kollektoranschlußfleck (30kl bzw. 30mn) zugeordnet ist, in den die Kollektorsammelleitung (03kl bzw. 03mn) der Zelle mündet, und daß zwischen den Kollektoranschlußflecken (30kl, 30mn) einer Zeile des Leistungstransistors je ein Emitteranschlußfleck (40lm) vorgesehen ist, in den die beiden miteinander zusammenhängenden Emittersammelleitungen (04lm) der am Rand der aneinandergrenzenden Zellen liegenden Halbzellen (l und m) münden.

7. Elektronisches Gerät nach Anspruch 4 oder 6, dadurch gekennzeichnet, daß in dem monolithisch integrierten Leistungstransistor zwei Transistorzeilen vorgesehen sind, von denen die zweite spiegelbildlich zur ersten so angeordnet ist, daß die Emitter- und Kollektoranschlußflecken (40lm; 30kl, 30mn) des monolithisch integrierten Leistungstransistors an zwei aneinander gegenüberliegenden Außenkanten des monolithisch integrierten Schaltungsteils des elektronischen Geräts verlaufen.

8. Elektronisches Gerät nach Anspruch 7, dadurch gekennzeichnet, daß zwischen den beiden Transistorzeilen des monolithisch integrierten Leistungstransistors neben Versorgungsleitungen (200; 02k, 02l; 02m, 02n; ...) weitere Schaltungsteile, beispielsweise Treiberstufen mit ihren zugehörigen Transistoren (93kl, 93mn, ...) und deren Emittervorwiderständen (94k, 94l; 94m, 94n; ...) sowie zum Schutz gegen Überspannungen gegebenenfalls erforderliche Komponenten, insbesondere Z-Dioden, angeordnet sind.

9. Elektronisches Gerät nach einem der Ansprüche 2-8, dadurch gekennzeichnet, daß der Leistungstransistor derart ausgebildet ist, daß die mittlere Stromdichte der Zellen, die im Kern des Leistungstransistors angeordnet sind, geringer ist als die mittlere Stromdichte der am Rand des Leistungstransistors liegenden Zellen, so daß der Leistungstransistor beim Betrieb über die ganze von ihm eingenommene Fläche mindestens annähernd gleich warm wird.

10. Elektronisches Gerät nach Anspruch 9, dadurch gekennzeichet, daß zur Reduzierung der Stromdichte eines Teiltransistors (1, 2, 3, ... n) des Leistungstransistors die Stromdichte im Emitter (11, 12, 13, ... 1n) des Teiltransistors (1, 2, 3, ..., n) reduziert ist durch Vergrößern seiner Emitterfläche und/oder durch Vergrößern des Widerstandes (41, 42, 43, ... 4n) in seiner Emitterzuleitung.

11. Elektronisches Gerät nach einem der Ansprüche 2 bis 10, dadurch gekennzeichnet, daß mindestens einer der Widerstände (41, 42, 43, ..., 4n) in den Emitterzuleitungen pro Zelle des Leistungstransistors als Meßwiderstand zur Gewinnung der Signalspannung dient und daß zwischen dem emitterseitigen Potentialabgriff des Meßwiderstandes und einer zur Auskopplung der Signalspannung dienenden Auskoppelleitung (70) für jeden Meßwiderstand mindestens ein diesem zugeordneter Entkopplungswiderstand (71, 72, 73, ... 7n) angeordnet ist.

12. Elektronisches Gerät nach einem der Ansprüche 1 bis 11, dadurch gekennzeichnet, daß die in den Emitterzuleitungen der Teiltransistoren (1, 2, 3, ..., n) des Leistungstransistors liegenden Widerstände (41, 42, 43, ..., 4n) einen positiven Temperaturkoeffizienten aufweisen.

13. Elektronisches Gerät nach einem der Ansprüche 1 bis 12, dadurch gekennzeichnet, daß die in den Emitterzuleitungen der Teiltransistoren (1, 2, 3, ..., n) des Leistungstransistors liegenden Widerstände (41, 42, 43, ..., 4n) außerhalb der als Basis für die Teiltransistoren (1, 2, 3, ..., n) dienenden Zone (2k, 2l, 2m, ...) angeordnet sind.

14. Elektronisches Gerät nach Anspruch 13, dadurch gekennzeichnet, daß die Widerstände (41, 42, 43, ..., 4n) in den Emitterzuleitungen aus Zonen mit Emitterdiffusion bestehen, die in einer aus p-dotiertem Material, beispielsweise aus Basismaterial bestehenden Zone (91k, 91l, 91m, ...) untergebracht sind, die von der zugehörigen Basiszone (2k, 2l, 2m, ...) des Teiltransistors durch Kollektormaterial getrennt ist.

15. Elektronisches Gerät nach Anspruch 14 mit einem monolithisch integrierten Leistungstransistor in einer Ausführung als npn-Transistor, dadurch gekennzeichnet, daß die aus p-dotiertem Material bestehende p-leitende Zone (91k, 91l, 91m, ...), in der die in den Emitterzuleitungen der Teiltransistoren liegenden Widerstände (41, 42, 43, ..., 4n) untergebracht sind, auf ein Potential gelegt ist, das niedriger ist als das Potential der die Basis der Teiltransistoren bildenden p-leitenden Zone (2k, 2l, 2m, ...).

16. Elektronisches Gerät nach einem der Ansprüche 11 bis 15, dadurch gekennzeichnet, daß die Entkopplungswiderstände (71, 72, 73, ... 7n) außerhalb der als Basis für die Teiltransistoren (1, 2, 3, ..., n) dienenden Zone (2k, 2l, 2m, ...) angeordnet sind.

17. Elektronisches Gerät nach Anspruch 16, dadurch gekennzeichnet, daß die Entkopplungswiderstände (71, 72, 73, ..., 7n) aus Zonen mit Emitterdiffusion bestehen, die in einer aus p-dotiertem Material bestehenden Zone (91k, 91l, 91m, ...) untergebracht sind, die von der zugehöriges Basiszone (2k, 2l, 2m, ...) des Teiltransistors durch Kollektormaterial getrennt ist.

18. Elektronisches Gerät nach Anspruch 16 oder 17, dadurch gekennzeichnet, daß die Entkopplungswiderstände (71, 72, 73, ..., 7n) und die in den Emitterzuleitungen der Teiltransistoren des Leistungstransistors liegenden Widerstände (41, 42, 43, ..., 4n) in derselben Diffusionszone (91k, 91l, 91m, ...) untergebracht sind.

19. Elektronisches Gerät nach einem der Ansprüche 12 bis 18, dadurch gekennzeichnet, daß die Auskoppelleitung (70) für die Signalspannung als n-dotierte Diffusionszone vergraben in dem einkristallinen Halbleitermaterial des monolithisch integrierten Leistungstransistors untergebracht ist.

20. Elektronisches Gerät nach Anspruch 19, dadurch gekennzeichnet, daß die n-dotierte Diffusionszone, die die Auskoppelleitung für die Signalspannung bildet, aus Emittermaterial (006) besteht.

21. Elektronisches Gerät mit einem in Bipolar-Epitaxialtechnik ausgeführten monolithisch integrierten Leistungstransistor nach Anspruch 19, dadurch gekennzeichnet, daß die n-dotierte Diffusionszone, die die Auskoppelleitung für die Signalspannung bildet, aus Leitschichtmaterial (001) besteht.

22. Elektronisches Gerät mit einem in Bipolar-Epitaxialtechnik ausgeführten monolithisch integrierten Leistungstransistor nach Anspruch 19, dadurch gekennzeichnet, daß die n-dotierte Diffusionszone, die die Auskoppelleitung (071m) für die Signalspannung bildet, aus Kollektoranschlußdiffusionsmaterial (004) besteht.

23. Elektronisches Gerät mit einem in Bipolar-Epitaxialtechik ausgeführten monolithisch integrierten Leistungstransistor nach einem der Ansprüche 2 bis 22, dadurch gekennzeichnet, daß zwischen einer nach außen führenden Emittersammelleitung (041m, ...) einer Zelle des Leistungstransistors und der n-dotierten Leitschicht (001) der Zelle eine auf der Leitschicht (001) aufsitzende p-dotierte Zone angeordnet ist, die mit der Leitschicht (001) eine Z-Diode (9) bildet.

24. Elektronisches Gerät nach Anspruch 23, dadurch gekennzeichnet, daß die auf der Leitschicht (001) aufsitzende p-dotierte Zone eine Isolierungsdiffusionszone (002, 003) des monolithisch integrierten Leistungstransistors ist.

25. Elektronisches Gerät nach Anspruch 23, dadurch gekennzeichnet, daß die auf der Leitschicht aufsitzende p-dotierte Zone eine auf der Leitschicht (001) implantierte Zone ist, wobei die Durchbruchspannung der gebildeten Z-Diode (9) mittels der Implantationsdosis eingestellt ist.

26. Elektronisches Gerät nach einem der Ansprüche 23 bis 25, dadurch gekennzeichnet, daß die Z-Diode (9) in einzelne Teildioden unterteilt ist, die jeweils auf Lücke zwischen den in den Emitterzuleitungen der Teiltransistoren (1, 2, 3, n) liegenden Widerständen (41, 42, ..., 4n) der Zellen des Leistungstransistors angeordnet sind.

27. Elektronisches Gerät nach einem der Ansprüche 3 bis 26, dadurch gekennzeichnet, daß eine Kollektorsammelleitung (03kl, 03mn) jeder Zelle mit einem der Zelle zugeordneten Anschlußfleck (30kl, 30mn) über eine Metallisierung (95kl, 95mn) verbunden ist, deren Querschnitt, vorzugsweise durch Erzeugen einer Engstelle, so ausgelegt ist, daß sich eine im Betrieb defekt werdende Zelle von den Kollektoren der intakten Zellen durch Abbrennen der Metallisierung (95kl, 95mn) abzutrennen vermag.

28. Elektronisches Gerät nach Anspruch 27, dadurch gekennzeichnet, daß zur Entkopplung der Basisansteuerung einer defekten Zelle des Leistungstransistors gegen die intakten Zellen jeder Zelle ein Basisvorwiderstand (94k, 94l, 94m, 94n) vorgeschaltet ist.

29. Elektronisches Gerät nach einem der Ansprüche 2 bis 28, dadurch gekennzeichnet, daß das masseseitige Potential der an mindestens einem der Widerstände (41, 42, 43, ..., 4n) in den Emitterzuleitungen pro Zelle (101, 102, 103, ..., 10n) gewonnenen Signalspannung über einen Entkopplungswiderstand (81, 82, 83, ..., 8n bzw. 8lm in Figur 7) mit einer Sammelleitung (800) verbunden ist, die ein masseseitiges, vom Emitterstrom des Leistungstransistors unabhängiges Referenzpotential dem Regelkreis zuführt.

30. Elektronisches Gerät nach einem der Ansprüche 12 bis 29, dadurch gekennzeichnet, daß der positive Temperaturkoeffizient der als Meßwiderstand dienenden, in den Emitterzuleitungen der Teiltransistoren liegenden Widerstände (41, 42, 43, ..., 4n) mindestens teilweise mittels des über die Auslegung der Schaltung einstellbaren Temperaturkoeffizienten der zwischen Steuereingang und Basis des Leistungstransistors liegenden Steuerschaltungen kompensiert ist.

## Claims

1. Electronic device having a control loop for current control or current limitation, which includes a monolithically integrated bipolar power transistor, consisting of the parallel circuit of a multiplicity of individual partial transistors (1, 2, 3, ..., n) having resistors (41, 42, 43, ..., 4n) in their emitter feed lines for stabilizing the distribution of the total current over the individual partial transistors (1, 2, 3, ..., n), characterized in that at least one of the resistors (41, 42, 43, ..., 4n) in the emitter feed lines serves as precision resistor for obtaining a signal voltage which is proportional to the current.

2. Electronic device according to Claim 1, characterized in that the individual partial transistors (1, 2, 3, ..., n) are combined in a plurality of groups, a group forming a cell of the power transistor.

3. Electronic device according to Claim 2, characterized in that the collector regions of the individual cells (k, l or m, n) are insulated with respect to each other, a plurality of cells of the power transistor preferably being combined to form a transistor line.

4. Electronic device according to Claim 3, characterized in that each cell (k, l or m, n) of a line of the power transistor is assigned one emitter and collector connecting land each, lying side by side, for emitter or collector connecting lines which lead outward.

5. Electronic device according to Claim 3, characterized in that the cells (k, l or m, n) of a line of the power transistor consist in each case of two half-cells (k and l or m and n), arranged with respect to each other with mirror-image symmetry, in that for the two half-cells (k and l or m and n) a common collector bus (03kl or 03mn) is provided which runs in the centre of the cell (k, l or m, n), and in that for the two half-cells (k and l or m and n) emitter buses (04k and 04l or 04m and 04n), separate from each other, are provided which run at the two edges of the cell (k, l or m, n), and are of integral design with the respective emitter buses (04ik or 04lm or 04no) of the two half-cells which are part of the respectively bordering cells (h, i or k, l or m, n or o, p).

6. Electronic device according to Claim 5, characterized in that to collector or emitter connecting lines, leading outward, of each cell (k, l or m, n) of the power transistor a collector connecting land (30kl or 30mn) is assigned, into which the collector bus (03kl or 03mn) of the cell opens, and in that between the collector connecting lands (30kl, 30mn) of a line of the power transistor one emitter connecting land (40lm) each is provided, into which open the two emitter buses (04lm), connected to one another, of the half-cells (l and m) which lie at the edge of the cells which border on one another.

7. Electronic device according to Claim 4 or 6, characterized in that in the monolithically integrated power transistor two transistor lines are provided, of which the second is arranged with respect to the first with mirror-image symmetry in such a manner that the emitter and collector connecting lands (40lm; 30kl, 30mn) of the monolithically integrated power transistor run on two outer edges, which are opposite one another, of the monolithically integrated circuit part of the electronic device.

8. Electronic device according to Claim 7, characterized in that, in addition to supply lines (200; 02k, 02l; 02m, 02n; ...), further circuit parts, for example driver stages with their associated transistors (93kl, 93mn, ...) and their emitter bias resistors (94k, 94l; 94m, 94n; ...) as well as components which are possibly required as protection against overvoltages, in particular Zener diodes, are arranged between the two transistor lines of the monolithically integrated power transistor.

9. Electronic device according to one of Claims 2-8, characterized in that the power transistor is designed in such a manner that the mean current density of the cells arranged in the core of the power transistor is lower than the mean current density of the cells lying at the edge of the power transistor, so that during operation the power transistor assumes at least approximately the same temperature over the entire surface it occupies.

10. Electronic device according to Claim 9, characterized in that for reducing the current density of a partial transistor (1, 2, 3, ... n) of the power transistor, the current density in the emitter (11, 12, 13, ... 1n) of the partial transistor (1, 2, 3, ..., n) is reduced by increasing its emitter area and/or by increasing the resistor (41, 42, 43, ... 4n) in its emitter feed line.

11. Electronic device according to one of Claims 2 to 10, characterized in that at least one of the resistors (41, 42, 43, ..., 4n) in the emitter feed lines of each cell of the power transistor serves as precision resistor for obtaining the signal voltage and in that for each precision resistor at least one decoupling resistor (71, 72, 73, ... 7n) assigned thereto is arranged between the potential tap on the emitter side of the precision resistor and an extraction line (70) serving to extract the signal voltage.

12. Electronic device according to one of Claims 1 to 11, characterized in that the resistors (41, 42, 43, ..., 4n) lying in the emitter feed lines of the partial transistors (1, 2, 3, ..., n) of the power transistor have a positive temperature coefficient.

13. Electronic device according to one of Claims 1 to 12, characterized in that the resistors (41, 42, 43, ..., 4n) lying in the emitter feed lines of the partial transistors (1, 2, 3, ..., n) of the power transistor are arranged outside the region (2k, 2l, 2m, ...) serving as base for the partial transistors (1, 2, 3, ..., n).

14. Electronic device according to Claim 13, characterized in that the resistors (41, 42, 43, ..., 4n) in the emitter feed lines consist of regions which have emitter diffusion and are accommodated in a region (91k, 91l, 91m, ...) consisting of p-doped material, for example of base material, which region is separate from the associated base region (2k, 2l, 2m, ...) of the partial transistor by collector material.

15. Electronic device according to Claim 14 having a monolithically integrated power transistor in a design as npn transistor, characterized in that the p-conductive region (91k, 91l, 91m, ...) consisting of p-doped material, in which region the resistors (41, 42, 43, ..., 4n) lying in the emitter feed lines of the partial transistors are accommodated, is connected to a potential which is lower than the potential of the p-conductive region (2k, 2l, 2m, ...) forming the base of the partial transistors.

16. Electronic device according to one of Claims 11 to 15, characterized in that the decoupling resistors (71, 72, 73, ... 7n) are arranged outside the region (2k, 2l, 2m, ...) serving as base for the partial transistors (1, 2, 3, ..., n).

17. Electronic device according to Claim 16, characterized in that the decoupling resistors (71, 72, 73, ..., 7n) consist of regions having emitter diffusion, which regions are accommodated in a region (91k, 91l, 91m, ...) consisting of p-doped material, which region is separate from the associated base region (2k, 2l, 2m, ...) of the partial transistor by collector material.

18. Electronic device according to Claim 16 or 17, characterized in that the decoupling resistors (71, 72, 73, ..., 7n) and the resistors (41, 42, 43, ..., 4n) lying in the emitter feed lines of the partial transistors of the power transistor are accommodated in the same diffusion region (91k, 91l, 91m, ...).

19. Electronic device according to one of Claims 12 to 18, characterized in that the extraction line (70) for the signal voltage is accommodated in the monocrystalline semiconductor material of the monolithically integrated power transistor in a manner buried as n-doped diffusion region.

20. Electronic device according to Claim 19, characterized in that the n-doped diffusion region which forms the extraction line for the signal voltage consists of emitter material (006).

21. Electronic device having a monolithically integrated power transistor, which is designed using bipolar epitaxial technology, according to Claim 19, characterized in that the n-doped diffusion region forming the extraction line for the signal voltage consists of conductive layer material (001).

22. Electronic device having a monolithically integrated power transistor, which is designed using bipolar epitaxial technology, according to Claim 19, characterized in that the n-doped diffusion region forming the extraction line (071m) for the signal voltage consists of collector connection diffusion material (004).

23. Electronic device having a monolithically integrated power transistor, which is designed using bipolar epitaxial technology, according to one of Claims 2 to 22, characterized in that a p-doped region which is placed on the conductive layer (001) is arranged between an emitter bus (041m, ...), leading outward, of a cell of the power transistor and the n-doped conductive layer (001) of the cell, which region, together with the conductive layer (001), forms a Zener diode (9).

24. Electronic device according to Claim 23, characterized in that the p-doped region, placed on the conductive layer (001), is an insulating diffusion region (002, 003) of the monolithically integrated power transistor.

25. Electronic device according to Claim 23, characterized in that the p-doped region, placed on the conductive layer, is a region implanted on the conductive layer (001), the breakdown voltage of the Zener diode (9), which is formed, being set by means of the implantation dose.

26. Electronic device according to one of Claims 23 to 25, characterized in that the Zener diode (9) is subdivided into individual partial diodes which are arranged in each case in the gaps between the resistors (41, 42, ..., 4n), lying in the emitter feed lines of the partial transistors (1, 2, 3, ..., n), of the cells of the power transistor.

27. Electronic device according to one of Claims 3 to 26, characterized in that a collector bus (03kl, 03mn) of each cell is connected to a connecting land (30kl, 30mn), assigned to the cell, via a metallization (95kl, 95mn) whose cross-section is designed, preferably by producing a constriction, in such a manner that a cell, which becomes defective during operation, is able to separate itself from the collectors of the cells which are intact by burning off the metallization (95kl, 95mn).

28. Electronic device according to Claim 27, characterized in that for decoupling the base drive of a defective cell of the power transistor with respect to the cells which are intact a base bias resistor (94k, 94l, 94m, 94n) is connected upstream of each cell.

29. Electronic device according to one of Claims 2 to 28, characterized in that the potential on the earth side of the signal voltage, obtained from at least one of the resistors (41, 42, 43, ..., 4n) in the emitter feed lines for each cell (101, 102, 103, ..., 10n), is connected via a decoupling resistor (81, 82, 83, ..., 8n or 8lm in Figure 7) to a bus (800) which feeds a reference potential on the earth side and independent of the emitter current of the power transistor to the control loop.

30. Electronic device according to one of Claims 12 to 29, characterized in that the positive temperature coefficient of the resistors (41, 42, 43, ..., 4n), serving as precision resistor and lying in the emitter feed lines of the partial transistors, is at least partly compensated by means of the temperature coefficient, which can be set by designing the circuit in a particular manner, of the control circuits which lie between control input and base of the power transistor.

## Revendications

1. Appareil électronique comportant un transistor de puissance monolithique intégré, bipolaire, ayant un circuit de régulation pour réguler l'intensité ou limiter le courant, ce transistor étant formé du montage en parallèle d'un grand nombre de transistors partiels, séparés, (1, 2, 3, ..., n) avec des résistances (41, 42, 43, ..., 4n) dans leur ligne d'émetteur pour stabiliser la répartition du courant total entre les différents transistors partiels (1, 2, 3, ..., n), caractérisé en ce qu'au moins l'une des résistances (41, 42, 43, ..., 4n) des lignes d'émetteur sert de résistance de mesure donnant un signal de tension proportionnel à l'intensité.

2. Appareil électronique selon la revendication 1, caractérisé en ce que les différents transistors partiels (1, 2, 3, ..., n) sont réunis en plusieurs groupes, un groupe formant une cellule du transistor de puissance.

3. Appareil électronique selon la revendication 2, caractérisé en ce que le domaine du collecteur des différentes cellules (k, l ou m, n) sont isolés les uns des autres et de préférence un grand nombre de cellules du transistor de puissance est réuni en une ligne de transistors.

4. Appareil électronique selon la revendication 3, caractérisé en ce qu'à chaque cellule (k, l ou m, n) d'une ligne du transistor de puissance est associée chaque fois une surface de branchement d'émetteur et de collecteur, juxtaposées, pour les lignes de raccordement de l'émetteur et du collecteur conduisant à l'extérieur.

5. Appareil électronique selon la revendication 3, caractérisé en ce que les cellules (k, l ou m, n) d'une ligne du transistor de puissance sont formées chaque fois de deux demi-cellules (k, l ou m, n) disposées de manière symétrique, et en ce que pour les deux demi-cellules (k et l ou m et n) on a une ligne collectrice de collecteur, commune, (03kl ou 03mn) qui passe au milieu de la cellule (k, l ou m, n) et en ce que pour les deux demi-cellules (k et l ou m et n) il y a des lignes collectrices d'émetteur, distinctes (04k et 04l ou 04m et 04n) qui passent au niveau des deux bords de la cellule (k, l ou m, n) et sont réalisées en une seule pièce avec les lignes collectrices d'émetteur respectives (04ik, 041m ou 04no) des deux demi-cellules qui appartiennent aux cellules respectivement adjacentes (h, i ou k, l ou m, n ou op).

6. Appareil électronique selon la revendication 5, caractérisé en ce que pour les lignes de collecteur et d'émetteur conduisant à l'extérieur de chaque cellule (k, 1 ou m, n) du transistor de puissance il est prévu une surface de branchement de collecteur (30kl ou 30mn) dans laquelle débouche la ligne collectrice de collecteur (03kl ou 03mn) de la cellule et en ce qu'entre la surface de branchement de collecteur (30kl, 30 mn) d'une cellule du transistor de puissance il est prévu chaque fois une surface de branchement d'émetteur (40lm) dans laquelle débouchent les deux lignes collectrices d'émetteur (04lm) réunies des demi-cellules (l et m) adjacentes au niveau du bord.

7. Appareil électronique selon la revendication 4 ou 6, caractérisé en ce que dans le transistor de puissance, intégré, monolithique, on a deux lignes de transistor dont la seconde est symétrique par rapport à la première, les surfaces de branchement des émetteurs et des collecteurs (40lm ; 30kl, 30mn) du transistor de puissance intégré, monolithique, passent le long de deux bords extérieurs opposés de la partie de circuit intégré monolithique de l'appareil électronique.

8. Appareil électronique selon la revendication 7, caractérisé en ce qu'entre les deux lignes de transistors formant le transistor de puissance monolithique intégré, à côté des lignes d'alimentation (200 ; 02k, 02l ; 02m, 02n, ...) il y a d'autres parties de circuit, par exemple des étages d'entraînement avec leurs transistors correspondants (93kl, 93mn, ...) dont les résistances d'émetteur (94k, 94l ; 94m, 94n ; ...) ainsi que les composants nécessaires, le cas échéant pour la protection contre les surtensions, sont notamment des diodes Z.

9. Appareil électronique selon l'une des revendications 2 à 8, caractérisé en ce que le transistor de puissance est conçu pour que la densité moyenne du courant des cellules prévues dans le coeur du transistor de puissance est faible comme la densité moyenne de courant des cellules situées au bord du transistor de puissance pour qu'en fonctionnement le transistor de puissance soit pratiquement à la même température au moins sur toute la surface qu'il occupe.

10. Appareil électronique selon la revendication 9, caractérisé en ce que pour réduire la densité de courant d'un transistor partiel (1, 2, 3, ... n) du transistor de puissance, on réduit la densité du courant dans l'émetteur (11, 12, 13, ... 1n) du transistor partiel (1, 2, 3, ..., n) en augmentant sa surface d'émetteur et/ou en augmentant la résistance (41, 42, 43, ... 4n) dans sa ligne d'émetteur.

11. Appareil électronique selon l'une des revendications 2 à 10, caractérisé en ce qu'au moins l'une des résistances (41, 42, 43, ..., 4n) des lignes d'émetteur par cellule du transistor de puissance sert de résistance de mesure donnant le signal de tension et en ce qu'entre la prise de potentiel du côté de l'émetteur pour la résistance de mesure et une ligne de découplage (70) servant à découpler le signal de tension, pour chaque résistance de mesure, il y a au moins une résistance de découplage (71, 72, 73, ... 7n) associée.

12. Appareil électronique selon l'une des revendications 1 à 11, caractérisé en ce que les résistances (41, 42, 43, ..., 4n), situées dans les lignes d'émetteur des transistors partiels (1, 2, 3, ..., n) du transistor de puissance, présentent un coefficient de température positif.

13. Appareil électronique selon l'une des revendications 1 à 12, caractérisé en ce que les résistances (41, 42, 43, ..., 4n), situées dans les lignes d'émetteur des transistors partiels (1, 2, 3, ..., n) du transistor de puissance, se trouvent en dehors de la zone (2k, 2l, 2m, ...) servant de base aux transistors partiels (1, 2, 3, ..., n).

14. Appareil électronique selon la revendication 13, caractérisé en ce que les résistances (41, 42, 43, ..., 4n) des lignes d'émetteur sont formées de zones avec une diffusion d'émetteur et ces zones sont logées dans une matière à dopage p, par exemple dans la zone formée de la matière de base (91k, 91l, 91m, ...) qui sont séparées de la zone de base (2k, 2l, 2m, ...) correspondante du transistor partiel par la matière du collecteur.

15. Appareil électronique selon la revendication 14 avec un transistor de puissance intégré, monolithique, dans sa réalisation sous forme de transistor de type npn, caractérisé en ce que la matière à dopage p constituant la zone à conduction de type p (91k, 91l, 91m, ...) dans laquelle sont logées les résistances (41, 42, 43, ..., 4n) situées dans les lignes d'émetteur des transistors partiels, est mise à un potentiel inférieur à celui de la zone à conduction de type p (2k, 2l, 2m, ...) qui forme la base des transistors partiels.

16. Appareil électronique selon l'une des revendications 11 à 15, caractérisé en ce que les résistances de découplage (71, 72, 73, ... 7n) se trouvent à l'extérieur de la zone (2k, 2l, 2m, ...) servant de base aux transistors partiels (1, 2, 3, ..., n).

17. Appareil électronique selon la revendication 16, caractérisé en ce que les résistances de découplage (71, 72, 73, ..., 7n) sont formées de zones à diffusion d'émetteur logées dans la zone (91k, 91l, 91m, ...) formée de matière à dopage p, qui sont séparées de la zone de base correspondante (2k, 2l, 2m, ...) du transistor partiel par la matière du collecteur.

18. Appareil électronique selon la revendication 16 ou 17, caractérisé en ce que les résistances de découplage (71, 72, 73, ..., 7n) et les résistances (41, 42, 43, ..., 4n) situées dans les lignes d'émetteur des transistors partiels du transistor de puissance sont logées dans les mêmes zones de diffusion (91k, 91l, 91m, ...).

19. Appareil électronique selon l'une des revendications 12 à 18, caractérisé en ce que la ligne de découplage (70) du signal de tension est une zone de diffusion à dopage n enterrée dans le semi-conducteur monocristallin du transistor de puissance intégré, monolithique.

20. Appareil électronique selon la revendication 19, caractérisé en ce que la zone de diffusion à dopage n qui forme la ligne de découplage du signal de tension est en matière d'émetteur (006).

21. Appareil électronique avec un transistor de puissance, intégré, monolithique, réalisé en technique épitaxiale bipolaire selon la revendication 19, caractérisé en ce que la zone de diffusion à dopage n qui forme la ligne de découplage du signal de tension est en matériau de la couche conductrice (001).

22. Appareil électronique avec un transistor de puissance, intégré, monolithique, réalisé en technique épitaxiale bipolaire selon la revendication 19, caractérisé en ce que la zone de diffusion à dopage n qui forme la ligne de découplage (07lm) du signal de tension est en matière de diffusion pour le branchement de collecteur (004).

23. Appareil électronique avec un transistor de puissance, intégré, monolithique, réalisé en technique épitaxiale bipolaire selon l'une des revendications 2 à 22, caractérisé en ce qu'entre l'une des lignes collectrices d'émetteur (04lm, ...) conduisant à l'extérieur d'une cellule du transistor de puissance et la couche conductrice (001) à dopage n de la cellule, se trouve une zone à dopage p placée sur la couche conductrice (001), cette zone formant avec la couche conductrice (001) une diode (9) de type Z.

24. Appareil électronique selon la revendication 23, caractérisé en ce que la zone à dopage p placée sur la couche conductrice (001) est une zone de diffusion d'isolation (002, 003) du transistor de puissance intégré monolithique.

25. Appareil électronique selon la revendication 23, caractérisé en ce que la zone à dopage p placée sur la couche conductrice est une zone implantée dans la couche conductrice (001), la tension de claquage de la diode Z, (9) ainsi formée étant établie par la dose d'implantation.

26. Appareil électronique selon l'une des revendications 23 à 25, caractérisé en ce que la diode Z (9) est subdivisée en différentes diodes partielles qui sont prévues chaque fois dans l'intervalle des lignes d'émetteur des transistors partiels (1, 2, 3, ..., n) pour les cellules des transistors de puissance.

27. Appareil électronique selon l'une des revendications 3 à 26, caractérisé en ce qu'une ligne collectrice de collecteur (03kl, 03mn) de chaque cellule est reliée à une surface de branchement (30kl, 30mn) associée à l'une des cellules par une métallisation (95kl, 95mn) dont la section est conçue de préférence en créant un point étroit pour qu'une cellule devenant défectueuse en fonctionnement puisse être séparée des collecteurs des cellules intactes par combustion de la métallisation (95kl, 95mn).

28. Appareil électronique selon la revendication 28, caractérisé en ce que pour découpler la commande de base d'une cellule défectueuse du transistor de puissance par rapport aux cellules intactes, une résistance de base (94k, 94l, 94m, 94n) précède chaque cellule.

29. Appareil électronique selon l'une des revendications 2 à 28, caractérisé en ce que le potentiel du côté de la masse du signal de tension fourni par au moins l'une des résistances (41, 42, 43, ..., 4n) des lignes d'émetteur par cellule (101, 102, 103, ..., 10n) est relié par une résistance de découplage (81, 82, 83, ..., 8n ou 81m sur la figure 7) par une ligne collectrice (800) qui fournit au circuit de régulation un potentiel de référence du côté de la masse qui est indépendant du courant d'émetteur du transistor de puissance.

30. Appareil électronique selon l'une des revendications 12 à 29, caractérisé en ce que le coefficient de température positif des résistances (41, 42, 43, ..., 4n) situées dans les lignes d'émetteur des transistors partiels et servant de résistances de mesure, est compensé au moins partiellement par le coefficient de température réglable suivant la conception du circuit, des circuits de commande situés entre l'entrée de commande et la base du transistor de puissance.
